(19) Europäisches Patentamt
European Patent Office
Office européen des brevets

(11) **EP 3 835 743 B1**

(12) **FASCICULE DE BREVET EUROPEEN**

(45) Date de publication et mention
de la délivrance du brevet:
**16.10.2024 Bulletin 2024/42**

(21) Numéro de dépôt: **20213393.0**

(22) Date de dépôt: **11.12.2020**

(51) Classification Internationale des Brevets (IPC):
***G01K 7/42*** *(2006.01)* ***H02B 1/30*** *(2006.01)*

(52) Classification Coopérative des Brevets (CPC):
**G01K 7/427;** H02B 1/30

(54) **MÉTHODES ET SYSTÈMES DE SURVEILLANCE D'INSTALLATIONS ÉLECTRIQUES**

METHODEN UND SYSTEME ZUR ÜBERWACHUNG VON ELEKTRISCHEN ANLAGEN

METHODS AND SYSTEMS FOR MONITORING ELECTRICAL FACILITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2019 FR 1914307**

(43) Date de publication de la demande:
**16.06.2021 Bulletin 2021/24**

(73) Titulaire: **Schneider Electric Industries SAS
92500 Rueil-Malmaison (FR)**

(72) Inventeurs:
• **YOUSSEF, Wedian
38000 Grenoble (FR)**
• **SCHUSTER, Philippe
38000 Grenoble (FR)**
• **KILINDJIAN, Christophe
38000 Grenoble (FR)**
• **REYMOND, Bruno
38000 Grenoble (FR)**
• **MARIE, Sylvain
38000 Grenoble (FR)**
• **RILLING, Gabriel
38000 Grenoble (FR)**

(74) Mandataire: **Lavoix
62, rue de Bonnel
69448 Lyon Cedex 03 (FR)**

(56) Documents cités:
**US-A1- 2015 168 470 US-A1- 2018 261 996**

**Description**

La présente invention concerne des méthodes et des systèmes de surveillance d'installations électriques.

L'invention se rapporte plus particulièrement à des installations de distribution d'électricité, comme des armoires électriques ou des tableaux électriques, notamment dans le domaine de la basse tension, bien que cet exemple ne soit pas limitatif et que d'autres applications soient possibles.

En pratique, l'invention est applicable à toute installation électrique.

Dans de nombreuses installations commerciales, domestiques et industrielles, l'électricité provenant d'un fournisseur d'énergie est distribuée vers les utilisateurs finaux en passant par une ou par plusieurs installations de distribution.

Typiquement, de telles installations font périodiquement l'objet de visites de contrôle et d'opérations de maintenance préventive, visant à détecter et corriger d'éventuels défauts qui seraient susceptibles de nuire au bon fonctionnement de l'installation.

Par exemple, lors de telles visites, il est courant de rechercher des défauts thermiques, tels que des points chauds, avec des moyens de mesure spécifiques, tels que des caméras infrarouge. Ces points chauds peuvent survenir au niveau de connexions entre des éléments conducteurs traversés par des courants d'intensité élevée et peuvent être à l'origine d'incendies ou de problèmes de sécurité majeurs.

Toutefois, les méthodes de maintenance ne donnent pas entièrement satisfaction. D'une part, les intervalles de visite sont généralement espacés dans le temps et ne permettent pas de rendre compte d'un changement soudain (tel qu'une panne) pouvant avoir des conséquences adverses à très court terme. D'autre part, ces méthodes sont parfois longues et complexes à mettre en oeuvre.

De plus, de telles inspections nécessitent d'ouvrir l'armoire électrique dans laquelle est logée tout ou partie de l'installation électrique (étant entendu que celle-ci est généralement protégé de son environnement immédiat par une porte ou une trappe qui est normalement fermée), ce qui introduit, lors de la visite, des échanges thermiques qui ne sont pas représentatifs des conditions réelles de fonctionnement, au point de compliquer l'interprétation des données mesurées.

Le document US 2015/168470 A1 divulgue un procédé de détection de points chauds thermiques dans un système de distribution d'énergie. Le système de distribution d'énergie comprend un conducteur comprenant un point de connexion pour le couplage à un composant de distribution électrique. Le procédé consiste à mesurer une première température du conducteur au point de connexion, à estimer une seconde température du conducteur au point de connexion et à déterminer le moment où une différence entre la première température et la seconde température dépasse un premier seuil prédéterminé. L'estimation est basée au moins partiellement sur une quantité de courant électrique circulant à travers le conducteur.

Il existe donc un besoin pour des méthodes et des dispositifs permettant de surveiller une installation électrique, notamment dans le but de détecter, en continu lorsque l'installation est en cours de fonctionnement, une anomalie thermique.

Ainsi, selon un aspect, la présente invention concerne un procédé de surveillance d'une installation électrique selon la revendication 1.

Le fait de pouvoir détecter une anomalie thermique dans l'installation permet d'identifier rapidement l'apparition d'un défaut ou d'une situation susceptible d'engendrer un défaut pouvant compromettre la sécurité de l'installation. Cette détection est réalisée en continu lorsque l'installation est en cours de fonctionnement. Elle permet d'obtenir une bonne réactivité et peut être mise en oeuvre simplement, sans avoir besoin de mobiliser du personnel spécialement qualifié.

Selon des aspects avantageux mais non obligatoires, un tel procédé peut incorporer une ou plusieurs des caractéristiques suivantes, prises isolément ou suivant toute combinaison techniquement admissible :

- Le procédé comporte en outre une étape d'envoi d'un message alerte lorsqu'une anomalie thermique est détectée.
- Le calcul de l'indice numérique et la détection d'une anomalie sont réalisés par le dispositif électronique de traitement de données dans un serveur informatique distant, et dans lequel le procédé comporte une étape de transmission des données mesurées vers le dispositif électronique de traitement de données par une liaison de télécommunications.
- Les capteurs de température et les capteurs de courant sont couplés à un concentrateur de données configuré pour transmettre les données mesurées vers le dispositif électronique de commande par une liaison de télécommunication.

Selon un autre aspect, l'invention concerne un système de surveillance pour une installation électrique selon la revendication 5.

Selon un autre aspect, l'invention concerne une installation électrique selon la revendication 6.

L'invention sera mieux comprise et d'autres avantages de celle-ci apparaîtront plus clairement à la lumière de la description qui va suivre d'un mode de réalisation d'un procédé donnée uniquement à titre d'exemple et faite en référence aux dessins annexés, dans lesquels :

[Fig 1] la figure 1 est une représentation synoptique d'une installation de distribution électrique comportant un dispositif de surveillance conforme à des modes de réalisation ;
[Fig 2] la figure 2 est une représentation synoptique d'un modèle utilisé par le dispositif de surveillance de la figure 1 ;
[Fig 3] la figure 3 est un diagramme de flux d'un procédé de surveillance mis en oeuvre par le dispositif de surveillance de la figure 1 selon des modes de réalisation.

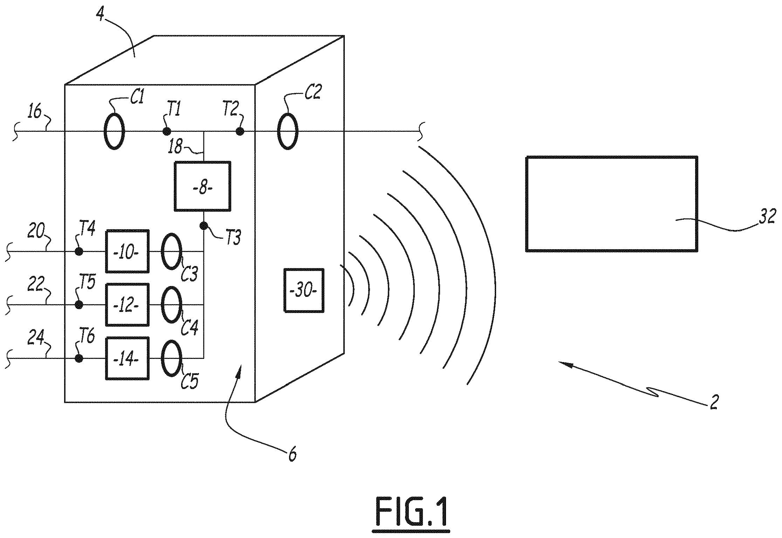

En référence à la figure 1 est représentée une installation électrique 2, telle qu'une installation de distribution d'électricité.

Dans cet exemple, l'installation 2 est disposée dans une armoire électrique 4 ou dans un coffret.

A titre d'exemple, l'installation 2 comporte un jeu de barres de raccordement 6, ou busbars, comprenant des conducteurs électriques interconnectés entre eux au moyen de boulons, de vis, de pièces de raccordement ou de connecteurs.

L'installation 2 peut également comporter un ou plusieurs appareils électriques, tels que des appareils de protection électrique ou des appareils de commutation, ou des appareils de mesure.

Dans cet exemple, l'installation 2 comporte quatre tels appareils, portant les références 8, 10, 12 et 14. Cet exemple n'est pas limitatif et de nombreuses autres configurations sont possibles.

Par exemple, lesdits appareils peuvent être des disjoncteurs, ou des contacteurs, ou des porte-fusibles, ou des relais, ou des sectionneurs, ou des interrupteurs, ou tout appareil équivalent.

De façon générale, les modes de mise en oeuvre de l'invention peuvent être implémentés dans toute installation électrique, et pas seulement une installation de distribution d'électricité.

Dans l'exemple illustré, un premier conducteur électrique 16 achemine de l'électricité provenant d'une source extérieure. Un deuxième conducteur électrique 18 et connecté au premier conducteur 16 et à des troisièmes conducteurs 20, 22 et 24 pour distribuer de l'électricité vers des appareils électriques situés en aval de l'installation 2 par l'intermédiaire de ces troisièmes conducteurs 20, 22 et 24.

Par exemple, l'appareil de protection 8 est associé au deuxième conducteur 18 et les appareils de protection 10, 12 et 14 sont associés, respectivement, aux troisièmes conducteurs 20, 22 et 24.

Cet exemple n'est pas limitatif et, là encore, de nombreuses autres architectures et configurations sont possibles.

L'installation 2 comporte également un système de surveillance plus particulièrement configuré pour détecter une anomalie thermique dans l'installation 2.

Par exemple, par anomalie thermique, on désigne ici une dérive dans le temps d'au moins une ou de plusieurs propriétés thermiques de l'installation 2, ces propriétés thermiques pouvant être des valeurs de la température à des emplacements précis de l'installation 2.

En pratique, une telle dérive thermique est souvent révélatrice d'un défaut d'origine électrique, ou d'une défaillance subite d'un composant, ou d'un défaut d'origine mécanique tel qu'un raccordement électrique mal branché, par exemple un mauvais serrage d'un boulon ou d'une vis au niveau d'une connexion électrique, ou tout autre défaut susceptible de porter préjudice au bon fonctionnement de l'installation.

Une telle dérive thermique peut également être révélatrice de modifications de comportements de composants vieillissants, ou d'altérations de propriétés d'échange de chaleur causées par l'accumulation de matériaux étrangers, tels que l'accumulation de poussière, ou l'obstruction d'un orifice d'aération.

Dans de nombreux modes de réalisation, le système de surveillance, dont des composants sont visibles sur la figure 1, comporte une pluralité de capteurs de courant, ici notés C1, C2, C3, C4 et C5, une pluralité de capteurs de température, ici notés T1, T2, T3, T4, T5, T6, et un dispositif électronique de traitement de données 32. Le nombre de capteurs de température et/ou de courant n'est pas limitatif et peut être différent sans changer le principe de l'invention.

Les capteurs de courant et de température peuvent être basés sur une technologie conventionnelle. Par exemple, les capteurs de courant sont des tores de mesure, tels que des capteurs de Rogowski. Les capteurs de température peuvent être des thermocouples, ou toute autre technologie de capteur appropriée.

Dans l'exemple illustré, deux capteurs de courant C1 et C2 sont placés sur le premier conducteur 16, en amont et en aval du point de connexion avec le deuxième conducteur 18 et un capteur de courant C3, C4, C5 est associé à chacun des troisièmes conducteurs 20, 22 et 24.

Toujours dans l'exemple illustré, les deux capteurs de température T1 et T2 sont associés au premier conducteur 16, en amont et en aval du point de connexion avec le deuxième conducteur 18, le capteur de température T3 est associé au deuxième conducteur 18 en amont des points de connexion avec les troisièmes conducteurs 20, 22 et 24, et les capteurs de température T4, T5, T6 sont respectivement associés aux troisièmes conducteurs 20, 22 et 24.

Cet exemple n'est pas limitatif et de nombreuses autres configurations sont possibles.

Optionnellement, le système de surveillance peut comporter un concentrateur de données 30, couplé aux capteurs de température et de courant, dont le rôle est de collecter les données mesurées par les capteurs de température et de courant et d'envoyer ces données vers le dispositif de traitement 32, notamment lorsque le dispositif de traitement 32 est placé à distance de l'armoire 4 et/ou qu'il n'est pas directement connecté auxdits capteurs.

Par exemple, le concentrateur 30 comporte une première interface de communication programmée pour recevoir des données provenant des capteurs, par exemple via une liaison filaire ou une liaison sans fil, de préférence une liaison radio de courte portée. Le concentrateur 30 comporte également une deuxième interface de communication, programmée pour transférer les données mesurées vers le dispositif de traitement 32, par exemple via une liaison filaire, ou une liaison sans fil, par exemple par le réseau internet, ou une liaison radio de longue portée, ou par un réseau de télécommunications de type 3G, ou 4G, ou 5G, ou tout autre moyen similaire.

Dans de nombreux modes de réalisation, le dispositif de traitement 32 comporte un processeur et une mémoire. Par exemple, le processeur est un microcontrôleur programmable ou un microprocesseur.

La mémoire est de préférence une mémoire informatique formant un support d'enregistrement de données lisible par ordinateur. Par exemple, la mémoire comporte une mémoire ROM, ou une mémoire RAM, ou une mémoire non volatile de type EEPROM, ou Flash, ou tout moyen équivalent.

La mémoire comporte des instructions exécutables et/ou un code logiciel pour mettre en oeuvre un procédé de surveillance de l'installation 2 tel que décrit ci-après lorsque ces instructions sont exécutées par le processeur.

En variante, le dispositif de traitement 32 peut être implémenté par un composant logique programmable de type FPGA ou par un circuit intégré dédié configuré pour mettre en oeuvre ledit procédé de surveillance.

De façon générale, le système de surveillance est notamment configuré pour mettre en oeuvre un procédé comportant des étapes consistant à :

- pendant que l'installation est en fonctionnement, mesurer au cours du temps des courants électriques qui circulent dans des conducteurs de l'installation et des valeurs de température en des emplacements prédéfinis de l'installation au moyen, respectivement, des capteurs de courant C1, C2, C3, C4, C5 et des capteurs de température T1, T2, T3, T4, T5, T6 préalablement disposés dans l'installation ;
- par le dispositif électronique de traitement de données 32 et à l'aide d'un modèle numérique préalablement acquis, calculer automatiquement un indice numérique représentatif de propriétés thermiques de l'installation, à partir d'écarts entre les valeurs de température mesurées et de valeurs de température correspondantes estimées au moyen dudit modèle à partir des valeurs de courant mesurées,
- par le dispositif électronique de traitement, détecter une anomalie thermique lorsque l'indice numérique calculé est différent d'une valeur de référence.

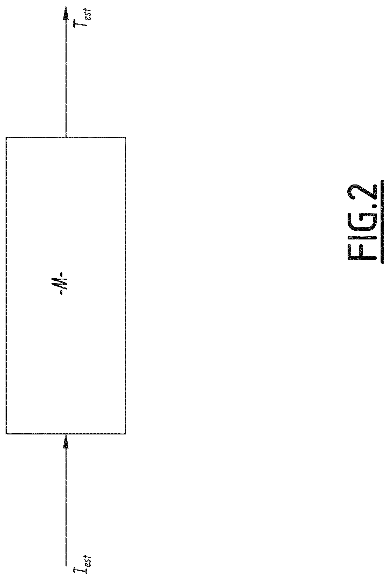

De préférence, comme illustré schématiquement à la figure 2, le modèle numérique, noté M, est représentatif de propriétés thermiques de l'installation électrique et est configuré pour associer des valeurs de courant mesurées, notées collectivement $I_{mes}$, par les capteurs de courant C1, C2, C3, C4, C5 à des valeurs de température estimées, notées collectivement $T_{est}$, pour les emplacements auxquels sont positionnés les capteurs de température T1, T2, T3, T4, T5, T6.

En d'autres termes, le modèle M est une estimation de la fonction de transfert qui lie pour chaque instant des températures à différents emplacements de l'installation à des valeurs de courants pour ce même instant et à des valeurs de température pour un instant de mesure immédiatement précédent.

En première approximation, le modèle M peut être un modèle linéaire ne prenant en compte que des échanges thermiques de premier ordre, les contributions non-linéaires d'ordre supérieur, par exemple dues à des phénomènes de convection, de conduction ou de radiation, pouvant être négligés dans un premier temps.

De préférence, les mesures sont réalisées de façon répétée pour une pluralité d'instants discrets ou pour des fenêtres de temps présentant une durée prédéfinie.

Les mesures peuvent être répétées de façon régulière ou périodique, avec une périodicité prédéfinie.

Selon des exemples préférés, la relation entre, d'une part, la température $\theta_t^i$ estimée pour un des emplacements à un instant donné (instant « t ») et, d'autre part, les valeurs de courant mesurées dans l'installation pour cet instant et les valeurs de températures pour l'instant précédent, est donnée par la formule suivante :

$$[Math] \ \theta_t^i = \alpha_i + \sum_{k=1}^{L}\sum_{l=1}^{m}\alpha_{k,l}\theta_{t-k}^l + \sum_{k=1}^{q}\sum_{l=1}^{m}\beta_{k,l}P_{t-k}^l + n_t$$

où :

$\theta_{t-1}^i$ désigne la température estimée pour ce même emplacement à un instant précédent (instant « t-1 »),
« $n_t$ » est le bruit statistique associé au capteur de température pour cet instant,
« m » est le nombre de capteurs de courant,
« L » est la durée de la fenêtre de mesure,

« P » est la puissance thermique qui dépend des courants mesurés, et plus particulièrement du carré des courants mesurés,

« α » et « β » sont des paramètres du modèle numérique, et

« k » et « I » sont des indices utilisés pour la sommation.

Par exemple, le modèle M peut être exprimé sous la forme d'une matrice à n lignes et à m colonnes (« n » étant le nombre de capteurs de température) et dont les coefficients sont des valeurs numériques.

Avantageusement, le modèle numérique M est préalablement paramétré par apprentissage sur l'installation électrique. Le modèle ainsi paramétré est ensuite stocké en mémoire du dispositif 32.

Par exemple, préalablement au démarrage de la surveillance de l'installation 2, on met en oeuvre une étape préalable de paramétrage du modèle numérique, cette étape comprenant des opérations consistant à :

pendant que l'installation est en fonctionnement, mesurer au cours du temps des courants électriques qui circulent dans des conducteurs de l'installation et des valeurs de température en des emplacements prédéfinis de l'installation au moyen, respectivement, des capteurs de courant C1, C2, C3, C4, C5 et des capteurs de température T1, T2, T3, T4, T5, T6 disposés dans l'installation ;

calculer des paramètres du modèle à partir des valeurs de courant et de température mesurées.

Par exemple, calculer les paramètres du modèle comporte une opération consistant à minimiser l'erreur quadratique donnée par la formule suivante, pour chaque couple de capteurs de courant et de température, à partir d'un jeu de données d'entraînement issus de l'installation et pour lesquels l'installation n'a subi aucune anomalie :

$$[Math] \quad \hat{\alpha}_{k,l}\hat{\beta}_{k,l} = \arg\min_{\alpha,\beta} \sum_t \sum_{i=0}^{m} (\theta_t^i - \alpha_0 - \sum_{k=1}^{L} \alpha_{k,l}\theta_{t-k}^l + \sum_{k=0}^{q} \sum_{l=1}^{n} \beta_{k,l} P_{t-k}^l)^2$$

où :

$\theta_t^i$ désigne la température mesurée pour l'emplacement indexé par l'indice « i » à un instant donné,

$\theta_t\text{-}1^i$ désigne la température mesurée pour ce même emplacement à un instant précédent,

« n » est le nombre de capteurs de température,

« m » est le nombre de capteurs de courant,

« L » est la durée de la fenêtre de mesure,

« P » est la puissance thermique qui dépend des courants mesurés et

$a_{k,l}\beta_{k,l}$ sont des paramètres du modèle numérique, correspondant ici à un coefficient de la matrice associée au modèle M (par exemple, les coefficients de la k-ième colonne et de la I-ième ligne).

Grâce à l'invention, le fait de pouvoir détecter une anomalie thermique dans l'installation permet d'identifier rapidement l'apparition d'un défaut ou d'une situation susceptible d'engendrer un défaut pouvant compromettre la sécurité de l'installation. Cette détection est réalisée en continu lorsque l'installation est en cours de fonctionnement. Elle permet d'obtenir une bonne réactivité et peut être mise en oeuvre simplement, sans avoir besoin de mobiliser du personnel spécialement qualifié.

Comme le modèle numérique est construit au moyen d'une phase d'apprentissage réalisée sur l'installation, la méthode peut être déployée sur n'importe quel type d'installation sans avoir besoin de paramétrage manuel. Au contraire, le modèle s'adapte automatiquement aux spécificités de l'installation pendant la phase d'apprentissage. En d'autres termes, la phase d'apprentissage permet de construire le modèle à partir d'une séquence de fonctionnement servant de référence (puisqu'on s'assure que l'installation ne souffre d'aucun défaut pendant ce laps de temps) à partir de laquelle des écarts à la normale sont ensuite identifiés.

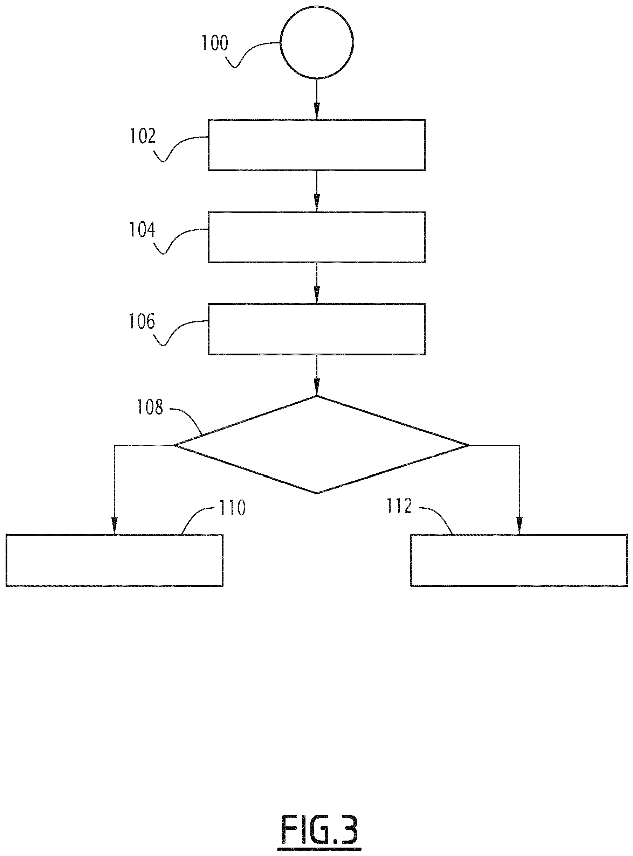

En référence à la figure 3 est décrit un exemple d'implémentation du procédé de surveillance de l'installation 2.

Cependant, en variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Le procédé est démarré lors d'une étape 100. Par exemple, antérieurement à cette étape 100, un modèle M paramétré en fonction des spécificités de l'installation 2 a été préalablement acquis.

Lors d'une étape 102, on mesure au cours du temps des courants électriques qui circulent dans des conducteurs de l'installation et des valeurs de température en des emplacements prédéfinis de l'installation au moyen, respectivement, des capteurs de courant C1, C2, C3, C4, C5 et des capteurs de température T1, T2, T3, T4, T5, T6 disposés dans l'installation. Les mesures peuvent être répétées dans le temps, comme expliqué précédemment.

Optionnellement, lors d'une étape 104, les données mesurées par les capteurs sont transmises vers le dispositif électronique de traitement de données 32 par une liaison de télécommunications.

Cette étape est par exemple mise en oeuvre lorsque le dispositif 32 est situé à distance de l'armoire 4, par exemple lorsque le dispositif 32 fait partie d'un serveur informatique distant.

Lors d'une étape 106, le dispositif 32 calcule automatiquement un indice numérique représentatif de propriétés thermiques de l'installation, à partir d'écarts entre les valeurs de température mesurées et de valeurs de température correspondantes estimées au moyen dudit modèle M à partir des valeurs de courant mesurées.

Par exemple, l'indice est représentatif d'un écart entre les températures mesurées par les capteurs à chaque instant et les températures correspondantes estimées pour ces instants grâce au modèle, cette estimation étant réalisée à partir des courants mesurés et des températures estimées pour l'instant précédent.

A titre d'exemple donné à des fins d'illustration, l'indice numérique est choisi égal au produit de la distance entre températures mesurées et températures estimées, cette distance étant ajustée par la corrélation estimée à l'issue de la phase de paramétrage et estimée sur les signaux de validation après la phase d'apprentissage. En d'autres termes, le modèle est ici établi en phase d'apprentissage à partir d'une majeure partie des données mesurées (par exemple 75% de ces données) puis validé avec des données différentes de celles ayant servi à construire le modèle (par exemple, les 25% de données restantes).

Cet exemple n'est pas limitatif et, en variante, d'autres indices numériques ou scores ou métriques peuvent être choisis.

Lors d'une étape 108, le système 32 compare automatiquement l'indice numérique, ou score, calculé avec une ou plusieurs valeurs de référence.

Par exemple, on peut préalablement définir un seuil de valeurs considéré comme correspondant à un fonctionnement normal.

L'installation 2 est alors considérée comme présentant une dérive anormale (étape 110) si le score calculé se trouve en dehors de cet intervalle. La ou les valeurs de référence peuvent être préalablement stockées en mémoire du dispositif 32.

En variante, seule une valeur de seuil peut être définie. On considère alors qu'une dérive anormale s'est produite (étape 110) si le score calculé se trouve supérieur (ou, dans d'autres exemples, inférieur) à la valeur de seuil.

Selon des variantes, la comparaison (étape 108) peut être réalisée sur un historique de valeurs du score calculé, une situation anormale étant alors considérée comme s'étant produite si le score reste en dehors d'un intervalle de valeurs normales (ou au-delà ou en-deçà d'une valeur de seuil) pendant une durée suffisamment longue, ceci de manière à éviter des faux positifs dus à une variation soudaine et inopinée.

Optionnellement, le procédé peut comporter une étape d'envoi d'un message alerte lorsqu'une anomalie thermique est détectée. Dans l'exemple illustré, le message est envoyé lors de l'étape 110.

Si aucune anomalie n'est détectée (étape 112), alors le procédé continue d'être mis en oeuvre, par exemple en répétant les étapes 102 à 108 précédemment décrites.

Toute caractéristique de l'un des modes de réalisation ou variante décrite ci-dessus, peut être mise en oeuvre dans les autres modes de réalisation et variantes décrits.

**Revendications**

1. Procédé de surveillance d'une installation électrique (2), comportant des étapes consistant à :

- pendant que l'installation est en fonctionnement, mesurer au cours du temps (102) des courants électriques qui circulent dans l'installation et des valeurs de température en des emplacements prédéfinis de l'installation au moyen, respectivement, de capteurs de courant (C1, C2, C3, C4, C5) et de capteurs de température (T1, T2, T3, T4, T5, T6) disposés dans l'installation ;
- par un dispositif électronique de traitement de données (32) et à l'aide d'un modèle numérique préalablement acquis (M), calculer automatiquement (106) un indice numérique représentatif de propriétés thermiques de l'installation, à partir d'écarts entre les valeurs de température mesurées et de valeurs de température correspondantes estimées au moyen dudit modèle à partir des valeurs de courant mesurées ;
- par le dispositif électronique de traitement, détecter une anomalie thermique (110) lorsque l'indice numérique calculé est différent d'une valeur de référence ;
dans lequel le modèle numérique (M) est représentatif de propriétés thermiques de l'installation électrique et est configuré pour associer des valeurs de courant mesurées (Imes) par les capteurs de courant (C1, C2, C3, C4, C5) à des valeurs de température estimées (Test) pour les emplacements auxquels sont positionnés les capteurs de température (T1, T2, T3, T4, T5, T6), **caractérisé en ce que** ce modèle numérique étant préalablement paramétré par apprentissage sur l'installation électrique en l'absence de défaut ;
dans lequel la relation entre la température estimée pour un des emplacements et les valeurs de courant mesurées dans l'installation est donnée par la formule suivante :

$$[\text{Math}] \quad \theta_t^i = \alpha_i + \sum_{k=1}^{L} \sum_{l=1}^{m} \alpha_{k,l} \theta_{t-k}^l + \sum_{k=1}^{q} \sum_{l=1}^{m} \beta_{k,l} P_{t-k}^l + n_t$$

où $\theta_t^i$ désigne la température estimée pour cet emplacement à un instant donné, $\theta_{t-1}^i$ désigne la température estimée pour ce même emplacement à un instant précédent, « n » est le bruit statistique associé au capteur de température pour cet instant, « m » est le nombre de capteurs de courant, « L » est la durée de la fenêtre de mesure, « P » est la puissance thermique qui dépend des courants mesurés et « α » et « β » sont des paramètres du modèle numérique ;
le procédé comportant en outre une étape préalable de paramétrage du modèle numérique, cette étape comprenant des opérations consistant à :

- pendant que l'installation est en fonctionnement, mesurer au cours du temps des courants électriques qui circulent dans des conducteurs de l'installation et des valeurs de température en des emplacements prédéfinis de l'installation au moyen, respectivement, des capteurs de courant (C1, C2, C3, C4, C5) et des capteurs de température (T1, T2, T3, T4, T5, T6) disposés dans l'installation ;
- calculer des paramètres du modèle à partir des valeurs de courant et de température mesurées ;

et dans lequel calculer les paramètres du modèle comporte une opération consistant à minimiser l'erreur quadratique donnée par la formule suivante, pour chaque couple de capteurs de courant et de température, à partir d'un jeu de données d'entraînement issus de l'installation et pour lesquels l'installation n'a subi aucune anomalie :

$$[\text{Math}] \quad \hat{\alpha}_{k,l} \hat{\beta}_{k,l} = \arg\min_{\alpha,\beta} \sum_t \sum_{i=0}^{m} (\theta_t^i - \alpha_0 - \sum_{k=1}^{L} \alpha_{k,l} \theta_{t-k}^l + \sum_{k=0}^{q} \sum_{l=1}^{n} \beta_{k,l} P_{t-k}^l)^2$$

où $\theta_t^i$ désigne la température mesurée pour cet emplacement à un instant donné, $\theta_{t-1}^i$ désigne la température mesurée pour ce même emplacement à un instant précédent, « n » est le nombre de capteurs de température, « m » est le nombre de capteurs de courant, « L » est la durée de la fenêtre de mesure, « P » est la puissance thermique qui dépend des courants mesurés et a et β sont des paramètres du modèle numérique.

2. Procédé selon la revendication 1, lequel comporte en outre une étape d'envoi (110) d'un message alerte lorsqu'une anomalie thermique est détectée.

3. Procédé selon l'une quelconque des revendications précédentes, dans lequel le calcul de l'indice numérique et la détection d'une anomalie sont réalisés par le dispositif électronique de traitement de données (32) dans un serveur informatique distant, et dans lequel le procédé comporte une étape de transmission (104) des données mesurées vers le dispositif électronique de traitement de données par une liaison de télécommunications.

4. Procédé selon l'une quelconque des revendications précédentes, dans lequel les capteurs de température et les capteurs de courant sont couplés à un concentrateur de données (30) configuré pour transmettre les données mesurées vers le dispositif électronique de commande par une liaison de télécommunication.

5. Système de surveillance pour une installation électrique, comportant une pluralité de capteurs de courant (C1, C2, C3, C4, C5) et une pluralité de capteurs de température (T1, T2, T3, T4, T5, T6) aptes à être disposés dans l'installation, et un dispositif électronique de traitement de données (32), le système de surveillance étant configuré pour mettre en oeuvre un procédé selon l'une quelconque des revendications précédentes.

6. Installation électrique (2) comportant un système de surveillance conforme à la revendication précédente.

**Patentansprüche**

1. Verfahren zur Überwachung einer elektrischen Anlage (2), das folgende Schritte umfasst:

- während die Anlage in Betrieb ist, Messen (102) von elektrischen Strömen, die in der Anlage fließen, und von Temperaturwerten an vordefinierten Stellen in der Anlage im Laufe der Zeit mittels Stromsensoren (C1, C2, C3, C4, C5) bzw. Temperatursensoren (T1, T2, T3, T4, T5, T6), die in der Anlage angeordnet sind;

- durch eine elektronische Datenverarbeitungsvorrichtung (32) und unter Verwendung eines zuvor erfassten digitalen Modells (M), automatisches Berechnen (106) eines digitalen Indexes, der für die thermischen Eigenschaften der Anlage repräsentativ ist, aus Abweichungen zwischen den gemessenen Temperaturwerten und entsprechenden Temperaturwerten, die mit Hilfe des Modells aus den gemessenen Stromwerten geschätzt werden;

- durch die elektronische Verarbeitungsvorrichtung eine thermische Anomalie (110) zu erkennen, wenn sich der berechnete numerische Index von einem Referenzwert unterscheidet;

wobei das digitale Modell (M) repräsentativ für die thermischen Eigenschaften der elektrischen Anlage ist und so konfiguriert ist, dass durch die Stromsensoren (C1, C2, C3, C4, C5) gemessene Stromwerte (Imes) mit geschätzten Temperaturwerten (Test) für die Orte, an denen die Temperatursensoren (T1, T2, T3, T4, T5, T6) positioniert sind, kombiniert werden, **dadurch gekennzeichnet, dass** dieses numerische Modell zuvor parametriert wurde durch Lernen an der elektrischen Anlage bei Abwesenheit eines Fehlers;

wobei die Beziehung zwischen der geschätzten Temperatur für einen der Orte und den gemessenen Stromwerten in der Anlage durch die folgende Formel gegeben ist:

$$[\text{Math}] \quad \theta_t^i = \alpha_i + \sum_{k=1}^{L}\sum_{l=1}^{m} \alpha_{k,l}\theta_{t-k}^l + \sum_{k=1}^{q}\sum_{l=1}^{m} \beta_{k,l}P_{t-k}^l + n_t$$

wobei $\theta_t^i$ die geschätzte Temperatur für diesen Ort zu einem bestimmten Zeitpunkt bezeichnet, $\theta_{t-1}^i$ die geschätzte Temperatur für denselben Ort zu einem vorherigen Zeitpunkt bezeichnet, "n" das statistische Rauschen ist, das zu diesem Zeitpunkt mit dem Temperatursensor verbunden ist, "m" ist die Anzahl der Stromsensoren, "L" ist die Dauer des Messfensters, "P" ist die Anzahl der Stromsensoren zu diesem Zeitpunkt, "P" ist die Wärmeleistung, die von den gemessenen Strömen abhängt, und "$\alpha$" und "$\beta$" sind Parameter des numerischen Modells;

wobei das Verfahren außerdem einen vorherigen Schritt der Parametrierung des digitalen Modells umfasst, wobei dieser Schritt folgende Vorgänge umfasst:

- während die Anlage in Betrieb ist, Messen von elektrischen Strömen, die in Leitern der Anlage fließen, und von Temperaturwerten an vordefinierten Stellen der Anlage im Laufe der Zeit mithilfe von Stromsensoren (C1, C2, C3, C4, C5) bzw. Temperatursensoren (T1, T2, T3, T4, T5, T6), die in der Anlage angeordnet sind;
- Modellparameter aus den gemessenen Strom- und Temperaturwerten berechnen;

und wobei das Berechnen der Modellparameter einen Vorgang umfasst, bei dem der quadratische Fehler, der durch die folgende Formel gegeben ist, für jedes Paar von Strom- und Temperatursensoren aus einem Satz von Antriebsdaten minimiert wird, die aus der Anlage stammen und für die die Anlage keine Anomalie erlitten hat:

$$[\text{Math}] \quad \hat{\alpha}_{k,l}\hat{\beta}_{k,l} = \arg\min_{\alpha,\beta} \sum_t \sum_{i=0}^{m} (\theta_t^i - \alpha_0 - \sum_{k=1}^{L} \alpha_{k,l}\theta_{t-k}^l + \sum_{k=0}^{q}\sum_{l=1}^{n} \beta_{k,l}P_{t-k}^l)^2$$

wobei $\theta_t^i$ die für diesen Ort zu einem bestimmten Zeitpunkt gemessene Temperatur bezeichnet, $\theta_{t-i}^i$ die für denselben Ort zu einem vorherigen Zeitpunkt gemessene Temperatur bezeichnet, "n" die Anzahl der Temperatursensoren ist, "m" die Anzahl der Stromsensoren, "L" die Dauer des Messfensters, "P" die Wärmeleistung, die von den gemessenen Strömen abhängt, und a und $\beta$ sind Parameter des digitalen Modells.

2. Verfahren nach Anspruch 1, das außerdem einen Schritt zum Senden (110) einer Warnmeldung umfasst, wenn eine thermische Anomalie erkannt wird.

3. Verfahren nach einem der vorhergehenden Ansprüche, wobei die Berechnung des numerischen Index und die Erkennung einer Anomalie von der elektronischen Datenverarbeitungsvorrichtung (32) in einem entfernten Computerserver durchgeführt wird, und wobei das Verfahren einen Schritt des Übertragens (104) der gemessenen Daten an die elektronische Datenverarbeitungsvorrichtung über eine Telekommunikationsverbindung umfasst.

4. Verfahren nach einem der vorhergehenden Ansprüche, bei dem die Temperatursensoren und die Stromsensoren mit einem Datenkonzentrator (30) gekoppelt sind, der so konfiguriert ist, dass er die gemessenen Daten über eine Telekommunikationsverbindung an das elektronische Steuergerät überträgt.

5. Überwachungssystem für eine elektrische Anlage, mit einer Vielzahl von Stromsensoren (C1, C2, C3, C4, C5) und einer Vielzahl von Temperatursensoren (T1, T2, T3, T4, T5, T6), die geeignet sind, in einer elektrischen Anlage angeordnet zu werden, und eine elektronische Datenverarbeitungsvorrichtung (32), wobei das Überwachungssystem so konfiguriert ist, dass es ein Verfahren nach einem der vorhergehenden Ansprüche ausführt.

6. Elektrische Anlage (2) mit einem Überwachungssystem gemäß dem vorhergehenden Anspruch.


**Claims**

1. Method of monitoring an electrical installation (2), comprising steps consisting of:

    - while the installation is in operation, measuring over time (102) electrical currents flowing in the installation and temperature values at predefined locations in the installation by means of current sensors (C1, C2, C3, C4, C5) and temperature sensors (T1, T2, T3, T4, T5, T6) arranged in the installation respectively;
    - by means of an electronic data processing device (32) and using a previously acquired digital model (M), automatically calculating (106) a digital index representative of thermal properties of the installation, on the basis of differences between the measured temperature values and corresponding temperature values estimated by means of said model on the basis of the measured current values;
    - by the electronic processing device, detect a thermal anomaly (110) when the calculated numerical index is different from a reference value;
    in which the digital model (M) is representative of thermal properties of the electrical installation and is configured to associate current values measured (Imes) by the current sensors (C1, C2, C3, C4, C5) with estimated temperature values (Test) for the locations at which the temperature sensors (T1, T2, T3, T4, T5, T6) are positioned, **characterised in that** this digital model has been parameterised beforehand by learning on the electrical installation in the absence of a fault;
    in which the relationship between the estimated temperature for one of the locations and the current values measured in the installation is given by the following formula:

$$[\text{Math}] \quad \theta_t^i = \alpha_i + \sum_{k=1}^{L}\sum_{l=1}^{m}\alpha_{k,l}\theta_{t-k}^l + \sum_{k=1}^{q}\sum_{l=1}^{m}\beta_{k,l}P_{t-k}^l + n_t$$

    where $\theta_t^i$ refers to the estimated temperature for this location at a given instant, $\theta_t\text{-}1^i$ refers to the estimated temperature for this same location at a previous instant, "n" is the statistical noise associated with the temperature sensor for this instant, "m" is the number of current sensors, "L" is the duration of the measurement window, "P" is the thermal power that depends on the measured currents and "$\alpha$" and "$\beta$" are parameters of the numerical model;
    the method also includes a prior step of parameterising the numerical model, this step comprising operations consisting of:

    - while the installation is in operation, to measure over time electrical currents flowing in conductors in the installation and temperature values at predefined points in the installation by means of current sensors (C1, C2, C3, C4, C5) and temperature sensors (T1, T2, T3, T4, T5, T6) arranged in the installation respectively;
    - calculate model parameters from measured current and temperature values;

    and in which calculating the parameters of the model comprises an operation consisting in minimising the square error given by the following formula, for each pair of current and temperature sensors, from a set of drive data from the installation and for which the installation has not suffered any anomaly:

$$[\text{Math}] \quad \hat{\alpha}_{k,l}\hat{\beta}_{k,l} = \arg min_{\alpha,\beta}\sum_t\sum_{i=0}^{m}(\theta_t^i - \alpha_0 - \sum_{k=1}^{L}\alpha_{k,l}\theta_{t-k}^l + \sum_{k=0}^{q}\sum_{l=1}^{n}\beta_{k,l}P_{t-k}^l)^2$$

    where $\theta_t^i$ is the temperature measured for that location at a given time, $\theta_t\text{-}1^i$ is the temperature measured for that same location at a previous time, "n" is the number of temperature sensors, "m" is the number of current sensors, "L" is the duration of the measurement window, "P" is the thermal power that depends on the measured currents and a and $\beta$ are parameters of the numerical model.

2. A method as claimed in claim 1, which further comprises a step of sending (110) an alert message when a thermal anomaly is detected.

3. A method according to any one of the preceding claims, in which the calculation of the numerical index and the detection of an anomaly are carried out by the electronic data processing device (32) in a remote computer server, and in which the method comprises a step (104) of transmitting the measured data to the electronic data processing device via a telecommunications link.

4. Method according to any of the preceding claims, in which the temperature sensors and the current sensors are coupled to a data concentrator (30) configured to transmit the measured data to the electronic control device via a telecommunications link.

5. A monitoring system for an electrical installation, comprising a plurality of current sensors (C1, C2, C3, C4, C5) and a plurality of temperature sensors (T1, T2, T3, T4, T5, T6) suitable for being disposed in the installation, and an electronic data processing device (32), the monitoring system being configured to implement a method according to any one of the preceding claims.

6. Electrical installation (2) comprising a monitoring system in accordance with the preceding claim.

FIG.1

FIG.2

100

102

104

106

108

110

112

FIG.3

**EP 3 835 743 B1**

## RÉFÉRENCES CITÉES DANS LA DESCRIPTION

**Documents brevets cités dans la description**

- US 2015168470 A1